Europäisches Patentamt

**European Patent Office**

**Office européen des brevets**

(11) Publication number: **0 461 843 A2**

# EUROPEAN PATENT APPLICATION

(21) Application number: **91305230.4**

(51) Int. Cl.⁵: $C23G\ 5/00$, $B08B\ 7/00$

(22) Date of filing: **11.06.91**

(30) Priority: **11.06.90 JP 152170/90**
**13.05.91 JP 107048/91**

(43) Date of publication of application:
**18.12.91 Bulletin 91/51**

(84) Designated Contracting States:
**DE FR GB IT**

(71) Applicant: **AGENCY OF INDUSTRIAL
SCIENCE AND TECHNOLOGY**
**3-1, 1-chome, Kasumigaseki
Chiyoda-ku Tokyo (JP)**
Applicant: **LAN TECHNICAL SERVICE CO.,
LTD.**
**45-11, Yoyogi 1-chome Shibuya-ku
Tokyo (JP)**
Applicant: **SEN LIGHTS CORPORATION**
**1-5-23, Hashirii
Toyonaka-city, Osaka-pref. (JP)**

(72) Inventor: **Katoh, Koichiroh, c/o Ind. Products
Research Inst.**
**1-1-4, Higashi
Tsukuba City, Ibaragi-Ken, 305 (JP)**
Inventor: **Matsumoto, Yoshiie, c/o LAN TECH.
SERVICE CO., LTD**
**45-11, Yoyogi 1-chome, Shibuya-ku
Tokyo (JP)**
Inventor: **Kikuchi, Kiyoshi, c/o SEN Lights
Corporation**
**1-5-23, Hashirii
Toyonaka-city, Osaka-pref. (JP)**

(74) Representative: **Pilch, Adam John Michael et
al**
**D. YOUNG & CO. 10 Staple Inn
London WC1V 7RD (GB)**

(54) **Methods of modifying metallic surfaces.**

(57) In a method of modifying a metallic surface having a poor adhesion to a material to be provided thereon before the material is provided on the surface of the metal, the surface of the metal is first irradiated with ultraviolet light having a 253.7 nm-wavelength, or with that having a 253.7 nm-wavelength and a 184.9 nm-wavelength.

EP 0 461 843 A2

The present invention relates to methods of modifying metallic surfaces, which methods enable materials (for example, paints, adhesives, inks, plating and/or coating resins) to be provided with good adhesion on metallic surfaces otherwise having poor adhesion thereto. The term "provide" used herein is intended to include the meaning "painting" when the material to be provided on the metallic surface is a paint, and "adhesion" when the material to be provided on the metallic surface is an adhesive.

Metals are extensively utilized as a basic constituent material of many products including electronic equipment, domestic electric appliances and automobiles. When an intended product involves utilization of a metal, it is a common practice to adhere a member comprising a metal (hereinafter referred to as "metallic member") to another metallic member or other component by means of an adhesive, or to paint or plate the surface of the metal for the purpose of improving the corrosion resistance and/or the appearance of the metal.

Some metals utilized in the above-described applications, for example, noble metals such as gold and platinum, metals having a surface capable of passivation such as aluminum, aluminum alloys and stainless steel, and various types of steel plate coated with a metal having a high corrosion resistance, for example, galvanized steel plate (galvanized sheet iron) and tinned steel plate (tin plate), advantageously bring about neither rusting nor other corrosion, or are less susceptible to rusting or other corrosion, but can have a disadvantage in that adhesion to a material to be provided thereon is poor.

For this reason, various proposals have been made for methods of modifying a metallic surface otherwise having a poor adhesion to a material to be provided thereon so that the material to be provided thereon can firmly adhere to the metallic surface. Specific examples thereof include the following methods (a) to (e):

(a) Blasting;
(b) Acid-alkali cleaning;
(c) Electrolytic oxidation;
(d) Salt bath cleaning;
(e) Chemical conversion.

The above methods are described in detail in, for example, "Kinzoku Hyomen Shori Yogo Jiten (Dictionary of Technical Terms on Metallic Surface Treatment)" published on October 25, 1983 (first edition) by Nikkan Kogyo Shinbun, Ltd.

In the above-described blasting process, however, a granular abrasive (for example, alumina powder) is collided against the surface of the metal at a high speed to roughen the surface of the metal, which causes the work environment or metallic member to be contaminated with the adhesive and/or causes the surface of the metallic member to be unfavourably finely deformed. This leads to problems such as troublesome cleaning work for the metallic member after treatment, and difficulty in treating a finely fabricated metallic member or a metallic member subjected to fabrication with a high degree of integration.

In the above methods (b) to (e), further, since a strong acid and/or a strong alkali are used, there arise problems such as difficult work environments, troublesome cleaning work for the metallic member after treatment, and the incurring of significant costs for antipollution measures.

Further, in the case of recent products which require a very high degree of cleanness, none of the above methods (a) to (e) have been regarded as a preferred method because they involve contamination of the work environment and of the metallic member itself.

Other examples of previously-proposed methods of improving the adhesion between the metallic surface and paint or adhesive include a method in which the surface of a metal is cleaned to a high degree, rather than actual modification of the metallic surface (see, for example, Yoichi Ohba, "Garasu Hyomen Sekkei-Senjo to Hyomen Shori (Design of Glass Surface-Cleaning and Surface Treatment)" published by Kindai Henshusha, p. 229. Fig. 1 of the accompanying drawings is a diagram from this document which shows the effect of such a cleaning method.

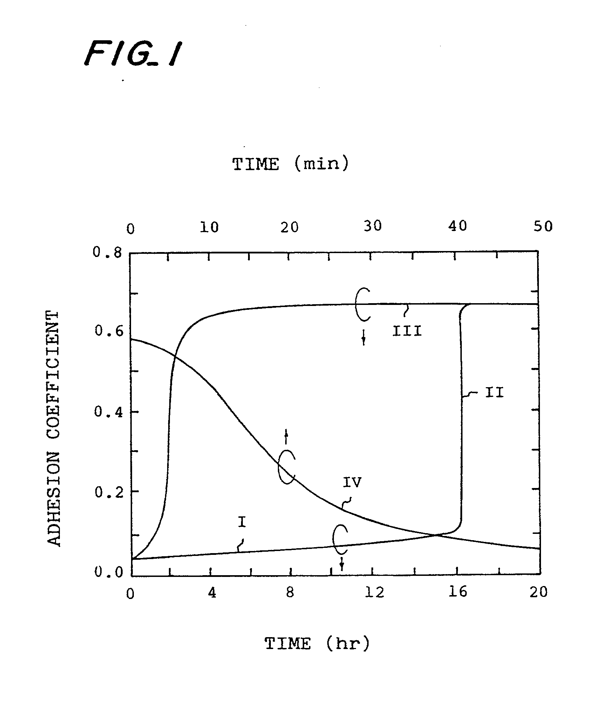

In Fig. 1, curve I is a characteristic curve showing the relationship between baking time and the degree of cleaning in a cleaning method wherein a material to be treated (gold is given as an example) is baked under a high degree of vacuum ($10^{-10}$o- Torr) at 200°C; curve II is a characteristic curve in a case where, subsequent to the treatment exemplified by the curve I, the treated material is then cleaned by sputtering of Ar (argon); curve III is a characteristic curve in a case where the material is then subjected to light cleaning through the use of an extra-high mercury lamp (ultraviolet radiation having a relatively long wavelength) having an output of 140 W; and curve IV is a curve showing recontamination (or resoiling) of the material subjected to cleaning. In Fig. 1, the ordinate represents a coefficient of adhesion showing the degree of cleanness of the material to be treated, the lower abscissa represents the cleaning treatment time for the material to be treated, and the upper abscissa represents the degree of recontamination after the cleaning treatment.

This cleaning method, however, exhibits no effect when the metallic surface is in a heavily contaminated state. Further, as is apparent from the curve IV in Fig. 1, the degree of cleanness of the treated material is unfavourably restored to the state before cleaning about 30 min. after the treated material has been allowed

2

to stand in an atmosphere having a cleanness (relatively clean atmosphere) similar to that of a normal laboratory (see the upper abscissa of Fig. 1). This makes it necessary to conduct painting, adhering, bonding, etc. within a few minutes after the cleaning treatment, which renders the above-described cleaning method unsuitable for most practical uses.

The present inventors have made extensive studies with a view to improving the adhesion between metallic surfaces and materials to be provided thereon and, as a result, have found that ultraviolet light having a relatively short wavelength and known as being effective for bringing about a photochemical or other reaction of an organic material is surprisingly useful for modification of a metallic surface having a poor adhesion to a material to be provided thereon.

Therefore, according to the present invention, there is provided a method of modifying a metallic surface, which method comprises modifying a metallic surface having a poor adhesion to a material to be provided thereon before the material is provided on the surface of said metal, wherein the surface of said metal is irradiated with ultraviolet light having a 253.7 nm-wavelength or ultraviolet light having a 253.7 nm-wavelength and a 184.9 nm-wavelength.

A preferred embodiment of the present invention, described more fully below, provides a method of modifying a metallic surface wherein the modification of the metallic surface can easily be conducted, no post-treatment is necessary, the modification effect can persist for a long period of time and the metallic surface can be modified without detriment to the shape of working even in the case of a finely fabricated metal member.

The ultraviolet light having a 253.7 nm-wavelength can be obtained by various methods. For example, it can readily be obtained through the use of a metal halide lamp, a high-pressure mercury lamp made of fused quartz of a natural rock crystal (hereinafter abbreviated to "fused quartz"), a high-pressure mercury lamp made of a synthetic quartz, a low pressure mercury lamp made of fused quartz or a low pressure mercury lamp made of synthetic quartz. The ultraviolet light having a 184.9 nm-wavelength and a 253.7 nm-wavelength can also be obtained by various methods. For example, it can readily be obtained through the use of a low-pressure mercury lamp made of synthetic quartz.

Suitable conditions for the modification of the metallic surface can be determined, for example, through the optimization of parameters such as the output of the lamp used, the distance between the lamp and the material to be treated and the irradiation time, according to the material, shape, size, etc. of the material to be modified.

As is apparent also from experimental results which will be described later, the above-described constitution enables a metallic surface having a poor adhesion to a material to be provided thereon to be modified to a surface state suitable for adhesion of the material to be provided thereon without use of any of an abrasive, an acid and an alkali in a short time (for example, through mere irradiation of the metallic surface with the above-described ultraviolet light for 60 sec. as described in the following working examples). Further, the modified state can be maintained for a period of time sufficient for use thereof on a commercial scale (for example, several days as described in the following working examples).

The reason why the metallic surface having a poor adhesion to a material to be provided thereon can be modified to a state suitable for adhesion of that material has not been elucidated yet. However, from the following two facts, the reason is believed to reside in that, in the method according to the present invention, an oxide film capable of rendering the metallic surface suitable for adhesion of the material to be provided thereon is formed on the metallic surface.

(1) First, the adhesion of a paint or an adhesive to a metat greatly varies depending upon the kind of the metal, and there is a tendency that the higher the rate of the formation of an oxide film, the better the adhesion of the paint or adhesive to the metal. This can be understood also from the results of the following experiments. Specifically, as is apparent from the experiments which will be described later, iron, copper and brass exhibit an excellent adhesion to a paint regardless of whether or not the surface modification has been conducted, or not. By contrast, aluminum, stainless steel, tin plate and galvanized iron each having a tower rate of formation of an oxide film than the above-described metals exhibits a very inferior adhesion to a paint when no surface modification is conducted.

(2) Second, even in the case if metals such, for example, as stainless steel, aluminum or other like, which have a poor adhesion to a material to be provided thereon, respectively, the adhesion has hitherto been improved by a surface modification treatment with an acid or an alkali. In other words, the adhesion has been improved by intentionally forming an oxide film on a metallic surface having a poor adhesion to a material to be provided thereon.

A further reason why an oxide film capable of rendering the metallic surface suitable for adhesion of the material to be provided thereon can rapidly be formed by the method of the present invention is believed as follows.

It is known that in the irradiation of a material with a light, when the energy of the irradiation light is higher than the bond energy of the material (hereinafter referred to as "material to be irradiated"), breaking of the bond occurs in the irradiated material which has absorbed the irradiation light, thereby bringing about an dissociation. Further, it is also known that the energy E of the irradiated light depends upon the wavelength $\lambda$ of the irradiated light and is expressed by the following equation:

$$E = hC/\lambda$$

wherein C is the speed of light (2.998 x 10$^8$ m/sec) and h is Planck's constant (6.626 x 10$^{-27}$o- erg.sec).

Therefore, it is apparent from the above-described equation that, in the ultraviolet light used in the present invention, the energy of the light having a wavelength of 253.7 nm is 4.9 eV (113 kcal) and the energy of the light having a wavelength of 184.9 nm is 6.7 eV (155 kcal).

If the material to be irradiated with the ultraviolet light is an organic material, as is apparent from the following Table 1 wherein bond energies of major chemical bonds between atoms constituting an organic material (quoted from "Kagaku Binran (Chemical Handbook)-Kiso Hen" published in 1966 by Maruzen in Japan) are given, many of the chemical bonds of the organic material have a bond energy smaller than the energy of a light having a wavelength of 184.9 nm or 253.7 nm. Therefore, in many cases, the above-described ultraviolet light effectively acts on an organic material for chemical decomposition thereof, and this has actually found wide applications in the art and has been used in, for example, water treatment for recovered water in the production of ultrapure water.

## Table 1

| Chemical bond | Bond energy (eV) |
| --- | --- |
| C – C | 3.6 |
| C = C | 6.3 |
| C – Cl | 3.4 |
| C – H | 4.3 |
| N ≡ N | 9.8 |
| O = O | 5.1 |
| O – H | 4.8 |
| S – N | 5.0 |

On the other hand, the bond energy of metals is much stronger than that of the organic material. Therefore, it is not recognized that the ultraviolet light has a great effect on the metals, so that no proposal has been made on the use of the ultraviolet light in the modification of the metallic surface. However, as is apparent from the following Table 2 quoted from "Saishin Hyomen Shori Gijutsu Soran (Comprehensive Bibliography on New Surface Treatment Techniques)", 48 (1989 ), published by Sangyo Gijutsu Service Center Co., Ltd. in japan, when attention is drawn to the energy of the bound electron (valence electron) of the outermost shell of metals, in some metals, (for example, aluminum (Al) and chromium (Cr) as given in the following Table 2 ), the energy of the valence electron is lower than the energy of the above-described ultraviolet light.

## Table 2

| Element | Bond energy of valence electron (eV) |
|---------|:---:|
| Al | 1 |
| Ti | 3 |
| Cr | 3 |
| Fe | 6. |
| Co | 3 |
| Ni | 4 |
| Cu | 2 |
| Zn | 9 |

It is also well known that when a metallic surface is irradiated with a light having an energy exceeding a given level, the electrons in the metal are excited and emitted. As is known in the art, the excitation and emission of the electrons causes vacancies to be formed in the outer shell of the metal, i.e., the metal to become a positive ion, and the vacancies to be immediately filled with other electrons, so that characteristic X-rays or other electrons derives from the Auger effect are emitted. It is also known that the electrons emitted by the above-described light irradiation are immediately returned to the metallic surface for rebonding or bonded to oxygen molecules or moisture in the air, thereby causing the gas to become a negative ion and that the metal in a positive ion form and the gas in a negative ion are apt to bond to each other, thereby bringing about a certain reaction.

In the above-described phenomenon around the metallic surface, it is believed that the ultraviolet light having a wavelength of 184.9 nm or both of a wavelength of 184.9 nm and a wavelength of 253.7 nm effectively excites and emits electrons from the metallic surface, thereby promoting the conversion of the metal to a positive ion form. Further, it is believed that the specific ultraviolet light used in the present invention exhibits such an action that the bonding between the above-described excited and emitted electrons and the oxygen molecule or moisture is promoted and consequently the conversion of the oxygen molecule or water vapor to a negative ion form is promoted. As a result, a dense and firm oxide film is rapidly formed on the surface of the metal. This oxide film becomes an underlying layer suitable for adhesion of a material to be provided thereon.

In particular, when the surface of a metal is irradiated with an ultraviolet light having a 184.9 nm-light and a 253.7 nm, since the light having a wavelength of 184.9 nm has an energy larger than the bond energy of oxygen molecule or water molecule, it acts on oxygen or water vapor in the air to generate a radical group, such as ozone, white the light having a wavelength of 253.7 nm decompose ozone to generate a nascent oxygen having a very strong oxidative power. As a result, the ultraviolet light having a wavelength of 253.7 nm and a wavelength of 184.9 nm form a dense, firm oxide film on the metallic surface in a shorter time than the ultraviolet light having a wavelength of 253.7 nm but not having a wavelength of 184.9 nm.

Although the relationship between ultraviolet light irradiation and oxygen has been described above, as is apparent also from the experimental results which will be described later, it should be noted that the metallic surface can be modified to a state suitable for adhesion of the material to be provided thereon even when the metallic surface is irradiated with an ultraviolet light in such a manner that the metal is placed in a nitrogen atmosphere. Although the reason why satisfactory results can be obtained in a nitrogen atmosphere has not been fully elucidated yet, it is believed to reside in that the nitrogen molecule is converted to a negative ion form by electrons exited and emitted from the metallic surface through the action of the ultraviolet light and the nitrogen molecule in a negative ion form acts on the metallic surface, thereby to cause a nitride film suitable for adhesion of a material to be provided on the metallic surface.

When the surface of a material is irradiated with an ultraviolet radiation in a nitrogen atmosphere, electrons are emitted out of the outermost orbit of electron orbits of the metal to form vacancies in the orbit. When oxygen in the air comes into contact with the vacancies in a state of not being recombined with the emitted electrons, oxygen is bonded to the vacancies to form an oxide film, which is believed to lead to a possibility of enhancing the adhesion of the surface of the metal. Since the atmosphere of nitrogen includes no substantial amount of oxygen, which absorbs a large amount an ultraviolet radiation with a wavelength of 184.9 nm, the amount of the ultraviolet radiation with a wavelength of 184.9 nm reaching the surface of the metal is so large that many vacancies may still remain even after most of the vacancies are filled through recombination of electrons and the like. This is believed to contribute to an increase in the amount of an oxide(s) formed on the surface (or in the surface portion) of-the metal to enhance the adhesion.

As is apparent from the foregoing description, according to the method of modifying a metallic surface according to the present invention, a simple irradiation of a metallic surface having a poor adhesion to a material to be provided thereon with either an ultraviolet light having a 253.7 nm-light or an ultraviolet light having a 184.9 nm and a 253.7 nm-light at a predetermined exposure enables the metallic surface to be modified to a state suitable for adhesion of the material to be provided thereon. Further, the modification effect can persist for a long period of time (for example, several days as described in the working example) sufficient for use on a commercial scale.

That is, the present invention provides a surface modification method wherein the surface modification treatment per se is simple, no post-treatment is necessary, the modification effect can persist for a long period of time and the metallic surface can be modified without detriment to the shape of working even in the case of a finely fabricated metallic member.

Therefore, according to the present invention, painting, plating or formation of other coatings on the surface of metals having a poor adhesion to a material to be provided thereon, for example, aluminum, aluminum-based alloys, stainless steel and zinc coated steel sheets, or adhesion of the metals of this kind can simply be conducted with a good adhesion, which renders the present invention very advantageous from the viewpoint of industry.

The foregoing and other features of the present invention will now become apparent to those skilled in the art from the following detailed description with reference to the accompanying drawings, in which:

Fig. 1 is a diagram for explaining the prior art;

Fig. 2 is a diagram showing a spectral energy distribution of a low-pressure mercury lamp made of synthetic quartz used in the working examples;

Fig. 3 is a graph showing the degree of attenuation of a radiant energy of a 184.9 nm-light and a 253.7 nm-light emitted from a low-pressure mercury lamp made of synthetic quartz used in the working examples in the relationship with the distance of an ultraviolet radiometer from the lamp;

Fig. 4 is a graph showing the results of one example of an experiment wherein aluminum is used as the material to be treated;

Fig. 5 is a graph showing the results of one example of an experiment wherein SUS-304 is used as the material to be treated; and

Fig, 6 is a graph showing the results of one example of an experiment wherein a galvanized plate (zinc coated steel) is used as the material to be treated.

The present invention will now be described in more detail by way of the following Examples, though it is not limited to these Examples only.

EXAMPLE 1: Surface modification of various metals

1-1. Preparation of samples

At the outset, the procedures for preparing experiment samples will be described.

In the present Example, a plurality of sheets of each of various metallic materials having a size of 50 mm x 50 mm described in the following items (A) to (C) were prepared as materials to be surface-treated.

(A): Two types of metals having a high corrosion resistance, i.e., SUS-304 (stainless steel having a chromium (Cr) content of 18 weight % and a nickel (Ni) content of 8 weight %) and aluminum (equivalent to pure aluminum).

(B): Two types of steel sheets having a high corrosion resistance, i.e., zinc (Zn) coated steel (galvanized iron) and tin (Sn) plate (tinned iron).

(C): Three types of metals which exhibit a high rate of formation of an oxide film, i.e., copper (Cu), brass and SUS-430 (stainless steel having a chromium (Cu) content of 18 weight %).

Then, the above-described metallic plates were well washed with a surfactant, tap water and first grade methanol in that order and then dried. This series of treatment are hereinafter referred to as "washing with a surfactant".

The washed metallic sheets thus obtained were used for the following surface treatments as EXAMPLE 1 and COMPARATIVE EXAMPLES 1 to 3 described in the following items (i) to (iv) under conditions described in the following items (i) to (iv). In COMPARATIVE EXAMPLE 3 described in the following item (iv), only washing of the metal sheets with tap water and ethanol and subsequent drying (this series of treatment are hereinafter referred to as "washing with a surfactant") were conducted, and no other special treatments were conducted.

Thereafter, the metal sheets immediately after the above-mentioned treatments (i) to (iv) and the metal sheets subjected to the treatments (i) to (iv) followed by standing in a room for 1.5, 4, 6 and 8 days were spray-painted with an acrylic lacquer (a black lacquer for iron and wood; a product of Dai Nippon Toryo Co., Ltd.) under the same conditions. After the painting, all the samples were allowed to stand in a room for 7 days, thereby drying the samples. Thus, painted samples of EXAMPLE 1 and COMPARATIVE EXAMPLES 1 to 3 were prepared for evaluation of surface treatment (see the following Tables 3 to 7).

Table 3

Dependence of remaining coating percentage (%) after coating crosscut test upon type of modification treatment (coating with paint immediately after modification treatment)

| Treated Material | (Ex. 1) UV irradiation | | (Comp. Ex. 1) solvent treatment + UV irradiation | | (Comp. Ex. 2) solvent treatment alone | (Comp. Ex.3) no modification treatment |
|---|---|---|---|---|---|---|
| | distance 35 mm | distance 65 mm | distance 35mm | distance 65 mm | | |
| SUS-304 | 100 | 100 | 98 | 91 | 1 | 3 |
| SUS-430 | 100 | 100 | 100 | 100 | 60 | 96 |
| copper | 100 | 100 | 100 | 97 | 99 | 78 |
| aluminum | 100 | 100 | 100 | 99 | 0 | 0 |
| brass | 100 | 100 | 100 | 100 | 100 | 90 |
| tin plate | 100 | 100 | 98 | 99 | 6 | 0 |
| zinc coated steel | 100 | 98 | 100 | 100 | 23 | 5 |

Note: In the table, the "distance" is one between the treated material and the low-pressure mercury lamp.

EP 0 461 843 A2

(i) Surface treatment conditions for EXAMPLE 1:

A plurality of sheets of each metallic material were sampled from the metallic sheets subjected to washing with a surfactant and irradiated with an ultraviolet light having a wavelength of 184.9 nm and a wavelength of 253. 7 nm to conduct a modification treatment of the samples of EXAMPLE 1. More specifically, the washed metallic sheets were put on a turn table of an ultraviolet irradiation device and irradiated with an ultraviolet light emitted from a low-pressure mercury lamp made of synthetic quartz and located 35 mm above the metallic sheets white rotating the turn table. The tamp used was a low-pressure mercury lamp made of synthetic quartz (Model: SUV-200GS, output: 200 W) manufactured by SEN Lights Corp., and the irradiation time was 60 sec. The ultraviolet irradiation was conducted in the air. The irradiation chamber was slightly evacuated by a ventilating fan.

Separately, a modification treatment was conducted in the same manner as that described above, except that the distance between the metallic sheets and the low-pressure mercury tamp made of a synthetic quartz was 65 mm instead of 35 mm.

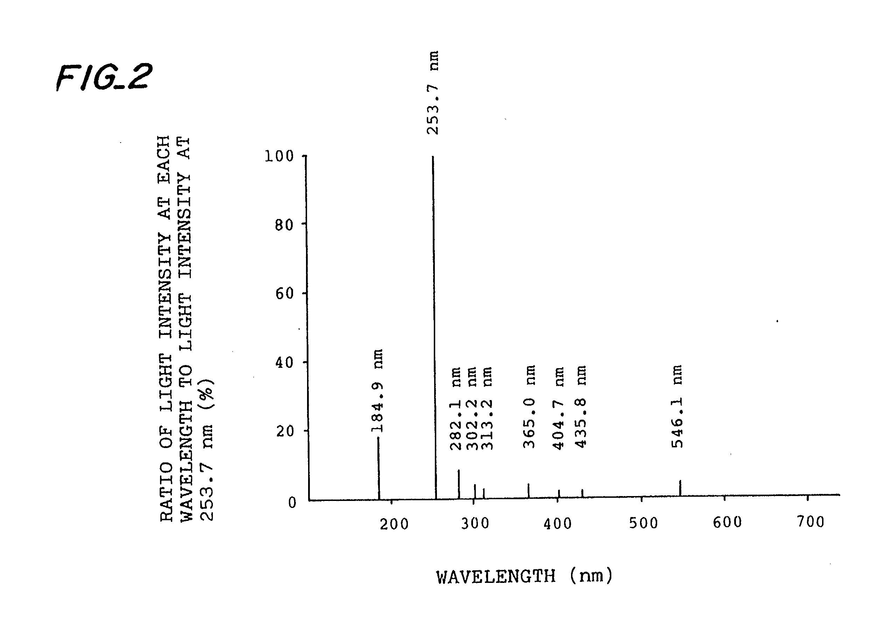

Fig. 2 is a spectral energy distribution of the Model SUV-200GS low-pressure mercury lamp made of synthetic quartz used in EXAMPLE 1. In Fig. 2, the abscissa represents the wavelength (nm), and the ordinate represents the ratio (%) of the light intensity at each of major wavelengths the light intensity at 253.7 nm emitted from the above-described lamp.

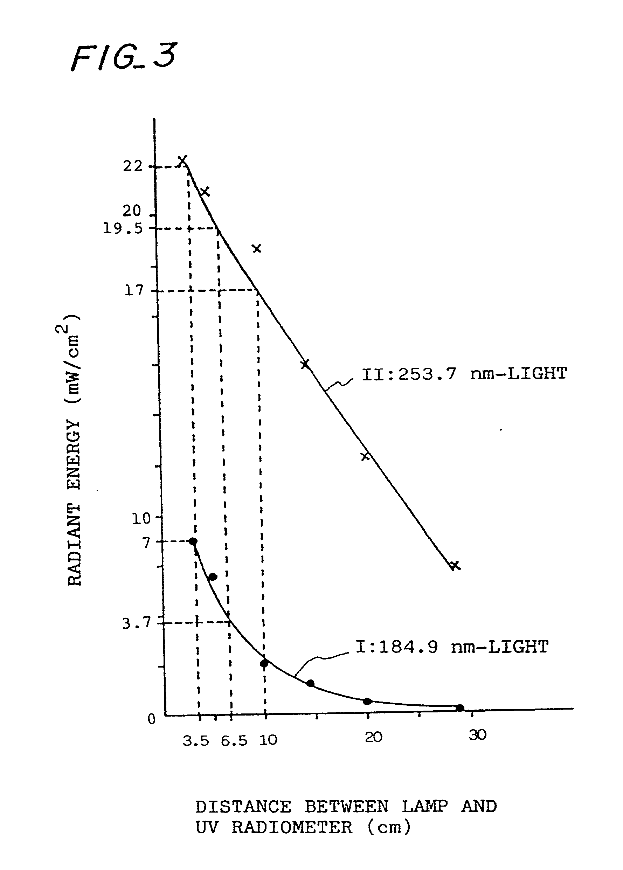

The radiant energy of the ultraviolet light at 184.9 nm and 253.7 nm emitted from the above-described lamp (SUV-200GS) was measured through the use of the distance between the radiometer and the lamp as a parameter. The measurement was conducted by making use of an ultraviolet radiometer of Model : C-1852 manufactured by Hamamatsu Photonics Co., Ltd. The results are shown in Table 12 which will be given later and Fig. 3. In Fig. 3, the abscissa represents the distance (cm) between the lamp and the radiometer, and the ordinate represents the radiant energy ($mW/cm^2$).

## Table 12

(Radiant energy of 184.9 nm-light and 253.7 nm-light emitted from low-pressure mercury lamp made of synthetic quartz)

| Distance between lamp and UV measuring apparatus (cm) | Radiant energy ($mW/cm^2$) | |
|---|---|---|
| | 184.9 nm-light | 253.7 nm-light |
| 3.0 | 7.1 | 22.2 |
| 5.0 | 5.6 | 21.0 |
| 10.0 | 2.1 | 18.6 |
| 14.5 | 1.3 | 13.9 |
| 20.0 | 0.5 | 10.2 |
| 29.0 | 0.2 | 6.0 |

From the data given in Table 12, it is possible to determine the ratio of the light intensity at 253.7 nm (hereinafter referred to as "$P_{254}$") to the light intensity at 184.9 nm (hereinafter referred to as "$P_{185}$", i.e., $P_{254}/P_{185}$. When the distance between the lamp and the radiometer is 3 to 29 cm, the $P_{254}/P_{185}$ value is about 3 to 30.

In the present example wherein the distance between the lamp and the metallic sheet is 35 mm or 65 mm, the radiant energy which the metallic sheet receive can be determined from Fig. 3. Specifically, when the distance between the lamp and the metallic sheet is 65 mm, the metallic sheet receives a 184.9 nm-light having a radiant energy of about 3.7 $mW/cm^2$ and a 253.7 nm-light having a radiant energy of about 19.5 $mW/cm^2$. Further, in the present example, since the metallic sheet was irradiated with the ultraviolet light for 60 sec, the exposure of the metallic sheet to the ultraviolet light emitted from the lamp can be determined by multiplying the above-described radiant energy by the irradiation time. When the distance between the tamp and the metallic sheet is 65 mm, the exposure of the metallic sheet to the 184.9 nm-light is 3.7 x 60 = 222 (mJ/cm$^2$) and the exposure of the metallic sheet to the 253.7 nm-light is 19.5 x 60 = 1170 (mJ/cm$^2$).

(ii) Surface treatment conditions for COMPARATIVE

EXAMPLE 1:

A plurality of sheets of each metallic material were sampled from the metallic sheets subjected to washing with a surfactant. These metallic sheets were immersed at room temperature in trichloroethylene for 1 min and then dried. This treatment with trichloroethylene is hereinafter referred to "solvent treatment". Thereafter, the treated metallic sheets were irradiated with an ultraviolet light in the same manner as that of EXAMPLE 1. As with EXAMPLE 1, in this COMPARATIVE EXAMPLE 1 as well, the ultraviolet irradiation was conducted under two irradiation distance conditions, i.e., at a distance between the metallic sheet and the tow-pressure mercury lamp of 35 mm and 65 mm.

(iii) Surface treatment conditions for COMPARATIVE

EXAMPLE 2:

A plurality of sheets of each kind of metallic material were sampled from the metallic sheets subjected to washing with a surfactant, and subjected to a solvent treatment in the same manner as that described in

COMPARATIVE EXAMPLE 1.

(iv) Surface treatment conditions for COMPARATIVE

EXAMPLE 3:

One sheet of each metallic material was sampled from the metallic sheets subjected to washing with a surfactant and painted as such.

1-2. Results of evaluation:

The coating of each sample thus prepared was crosscut into a squares form by means of a crosscut guide in such a manner that the length of a side of each square was 2 mm. A cellophane tape was put on the crosscut coating, and a peeling test was then conducted. Thereafter, with respect to each modification treatment, the adhesion of the coating to the metallic sheet was evaluated based on the percentage remaining coating (%) expressed by the following equation.

$$\text{Remaining coating percentage (\%)} = \frac{\text{Number of remaining coating squares}}{\text{Number of coating squares before peeling}} \times 100$$

The remaining coating percentage with respect to a group of metallic sheets samples which have been painted immediately after the modification treatment is given in Table 3 already shown in the former part of the instant specification. Further, the percentage remaining coating with respect to a group of metallic sheet samples which have been allowed to stand for 1.5 days, 4 days, 6 days and 8 days after the modification treatment and then painted will be given later in Tables 4 to 7.

Table 4

Dependence of remaining coating percentage (%) after coating crosscut test upon type of modification treatment (coating with paint at 1.5 days after modification treatment)

| Treated Material | (Ex. 1) UV irradiation | | (Comp. Ex. 1) solvent treatment + UV irradiation | | (Comp. Ex. 2) solvent treatment alone |
|---|---|---|---|---|---|
| | distance 35 mm | distance 65 mm | distance 35mm | distance 65 mm | ———————— |
| SUS-304 | 100 | 99 | 97 | 91 | 17 |
| SUS-430 | 100 | 100 | 99 | 97 | 94 |
| copper | not practiced | not practiced | not practiced | not practiced | not practiced |
| aluminum | 100 | 100 | 97 | 95 | 0 |
| brass | not practiced | not practiced | not practiced | not practiced | not practiced |
| tin plate | 100 | 100 | 87 | 80 | 2 |
| zinc coated steel | 100 | 62 | 97 | 43 | 17 |

Note: In the table, the "distance" is one between the treated material and the low-pressure mercury lamp, and "not practiced" means no irradiation of UV.

Table 5

Dependence of remaining coating percentage (%) after coating crosscut test upon type of modification treatment (coating with paint at 4 days after modification treatment)

| Treated Material | (Ex. 1) UV irradiation | | (Comp. Ex. 1) solvent treatment + UV irradiation | | (Comp. Ex. 2) solvent treatment alone |
|---|---|---|---|---|---|
| | distance 35 mm | distance 65 mm | distance 35mm | distance 65 mm | |
| SUS-304 | 100 | 100 | 90 | 95 | 30 |
| SUS-430 | 100 | 100 | 100 | 96 | 95 |
| copper | not practiced | not practiced | not practiced | not practiced | not practiced |
| aluminum | 100 | 100 | 97 | 90 | 0 |
| brass | not practiced | not practiced | not practiced | not practiced | not practiced |
| tin plate | 100 | 100 | 96 | 97 | 36 |
| zinc coated steel | 99 | 94 | 97 | 72 | 6 |

Note: In the table, the "distance" is one between the treated material and the low-pressure mercury lamp, and "not practiced" means no irradiation of UV.

## Table 6

Dependence of remaining coating percentage (%) after coating crosscut test upon type of modification treatment (coating with paint at 6 days after modification treatment)

| Treated Material | (Ex. 1) UV irradiation | | (Comp. Ex. 1) solvent treatment + UV irradiation | | (Comp. Ex. 2) solvent treatment alone |
|---|---|---|---|---|---|
| | distance 35 mm | distance 65 mm | distance 35mm | distance 65 mm | |
| SUS-304 | 100 | 100 | 100 | 100 | |
| SUS-430 | not practiced | not practiced | not practiced | not practiced | No test was conducted because the test results was clearly poor on coating 4 days after standing of the metal subjected to solvent treatment as given in Table 5. |
| copper | not practiced | not practiced | not practiced | not practiced | |
| aluminum | 100 | 100 | 99 | 99 | |
| brass | not practiced | not practiced | not practiced | not practiced | |
| tin plate | 99 | 100 | 99 | 94 | |
| zinc coated steel | 99 | 93 | 95 | 69 | |

Note: In the table, the "distance" is one between the treated material and the low-pressure mercury lamp, and "not practiced" means no irradiation of UV.

EP 0 461 843 A2

## Table 7

Dependence of remaining coating percentage (%) after coating crosscut test upon type of modification treatment (coating with paint at 8 days after modification treatment)

| Treated Material | (Ex. 1) UV irradiation | | (Comp. Ex. 1) solvent treatment + UV irradiation | | (Comp. Ex. 2) solvent treatment alone |
|---|---|---|---|---|---|
| | distance 35 mm | distance 65 mm | distance 35mm | distance 65 mm | |
| SUS-304 | 100 | 100 | 98 | 97 | |
| SUS-430 | 100 | 100 | 92 | 98 | No test was conducted because the test results was clearly poor on coating 4 days after standing of the metal subjected to solvent treatment as given in Table 5 |
| copper | 100 | 100 | 100 | 100 | |
| aluminum | 100 | 100 | 95 | 94 | |
| brass | not practiced | not practiced | not practiced | not practiced | |
| tin plate | 100 | 100 | 97 | 95 | |
| zinc coated steel | 80 | 66 | 57 | 93 | |

Note: In the table, the "distance" is one between the treated material and the low-pressure mercury lamp, and "not practiced" means no irradiation of UV.

EP 0 461 843 A2

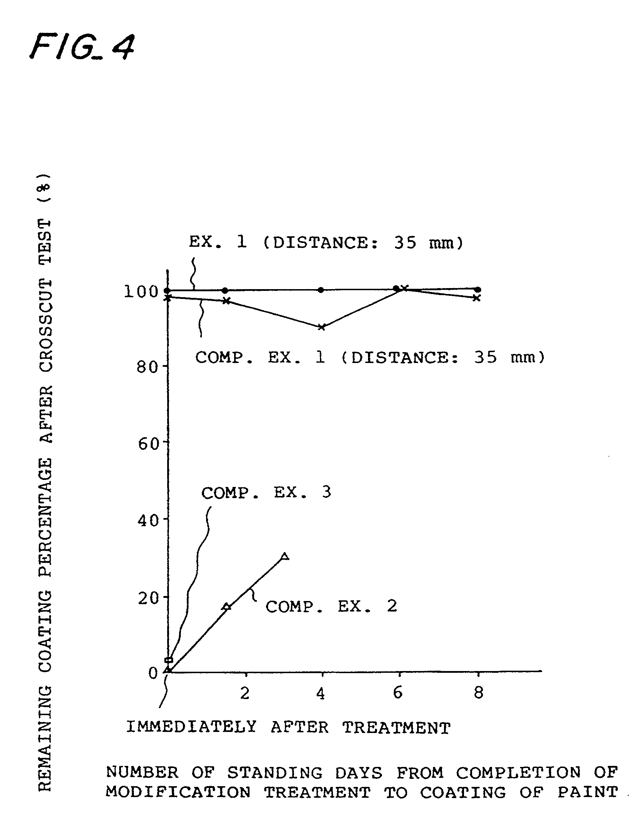

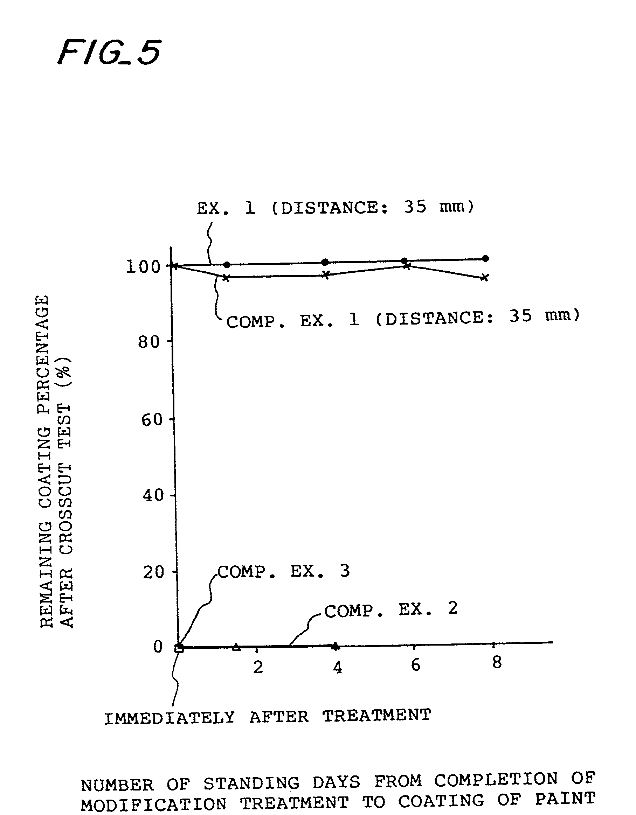

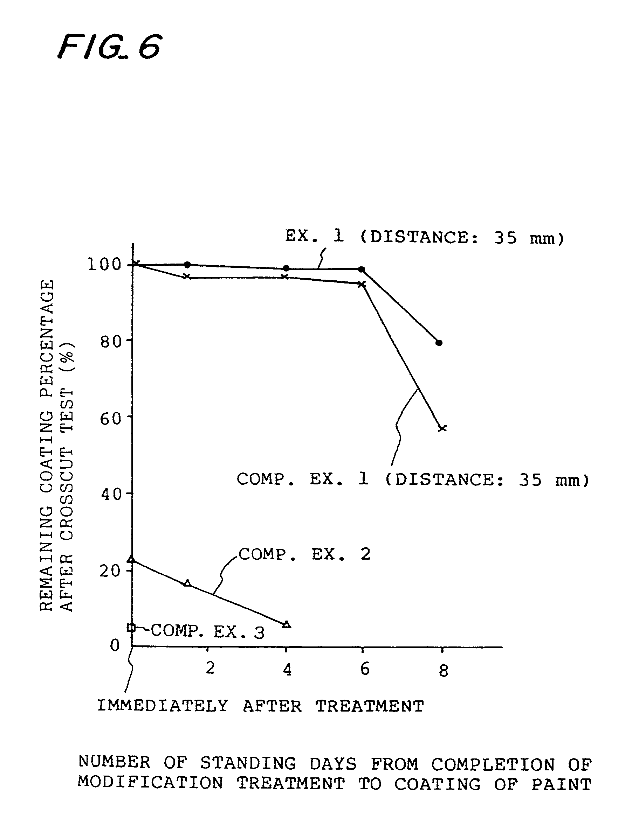

Figs. 4 to 6 show the relationship between the standing days and the percentage remaining coating, i.e., modification effect, with respect to the test results in each case where the material to be treated were aluminum, SUS-304 and zinc coated steel, among the test results given in Tables 3 to 7. In Figs. 4 to 6, the ordinate represents the above-described remaining coating, and the abscissa represents the number of days of standing of the sample from after the modification treatment to the coating of the paint.

1-3. Observation:

As is apparent from Tables 3 to 7 and figs. 4 to 6, stainless steel, aluminum and zinc coated steel having a high corrosion resistance can be remarkably improved in the coating adhesion by the modification method of the present invention. Therefore, according to the present invention, a metallic surface having a poor adhesion to a material to be provided thereon can be modified to such a state suitable for adhesion of the material to be provided thereon. Further, the modification effect can persist for at least 8 days after the modification treatment has been conducted. Although the adhesion of the coating to the zinc coated steel lowers when the treated zinc coated steel is allowed to for 8 days, this towering raises no problem because the coating adhesion on this level is sufficient for practical use.

Further, with respect to SUS-430, copper and brass which exhibit a higher oxide film formation rate than SUS-304, aluminum, etc., there is no need of using the modification method of the present invention because they exhibit a coating adhesion on a level sufficient for practical use regardless of whether or not the modification treatment is conducted and the treatment conditions.

EXAMPLE 2: Aluminum alloys and stainless steels having other composition than the stainless steel used in EXAMPLE 1

The present example demonstrates the application of the surface modification method of the present invention to aluminum-based alloys and stainless steels having other composition than SUS-304 and SUS-430. Seven kinds of aluminum alloys respectively having compositions 1 to 7 shown in Table 8 which will be given later, and 21 kinds of stainless steels respectively having compositions a to u shown in Table 9 which will be described later. In Tables 8 and 9, all the contents of individual components are represented in terms of % by weight, except that in Table 9 the description of the content of iron (Fe) as balance of each stainless steel is omitted. All the aluminum alloys and stainless steels given in Tables 8 and 9 are typical ones.

Table 8

(Composition of each aluminum alloy used in experiment)

| Composition | Si | Fe | Cu | Mn | Mg | Cr | Zn | Ti | Al |
|---|---|---|---|---|---|---|---|---|---|
| 1 | 0.12 | 0.55 | 0.12 | | | | | | 99.0 |
| 2 | 0.60 | 0.25 | 4.00 | 0.70 | 0.60 | | | 0.02 | balance |
| 3 | 0.30 | 0.55 | 0.12 | 1.07 | | | | | balance |
| 4 | 1.50 | 0.16 | | | | | | | balance |
| 5 | 0.08 | 0.27 | | | 2.60 | 0.18 | | | balance |
| 6 | 0.60 | 0.42 | 0.28 | | 1.00 | 0.25 | | | balance |
| 7 | 0.08 | 0.32 | 1.30 | | 2.70 | 0.20 | 5.50 | 0.07 | balance |

EP 0 461 843 A2

## Table 9

(Composition of stainless steel used in experiment (content of iron (Fe) as balance is omitted))

| Composition | C | Si | Mn | P | S | Ni | Cr | Mo | N | Others |
|---|---|---|---|---|---|---|---|---|---|---|
| a | 0.101 | 0.72 | 0.70 | 0.023 | 0.002 | 6.15 | 24.82 | 3.22 | 0.10 | |
| b | 0.019 | 0.50 | 0.39 | 0.014 | 0.002 | 9.54 | 18.54 | 0.71 | 0.133 | Cu 2.99 |
| c | 0.07 | 0.72 | 1.25 | 0.027 | 0.003 | 8.34 | 18.22 | - | - | |
| d | 0.015 | 0.15 | 0.97 | 0.019 | 0.003 | 19.15 | 25.25 | - | - | |
| e | 0.029 | 0.80 | 1.00 | 0.029 | 0.004 | 9.14 | 17.23 | 0.04 | - | Ti 0.342 |
| f | 0.105 | 0.65 | 1.38 | 0.027 | 0.004 | 7.37 | 17.48 | - | - | |
| g | 0.016 | 0.66 | 1.66 | 0.032 | 0.005 | 10.39 | 18.54 | - | - | |
| h | 0.042 | 0.80 | 1.04 | 0.015 | 0.002 | 19.29 | 24.99 | - | - | |
| i | 0.012 | 0.64 | 1.48 | 0.037 | 0.007 | 15.83 | 17.29 | 4.89 | - | |
| j | 0.04 | 0.58 | 1.70 | 0.032 | 0.011 | 15.27 | 16.65 | 5.13 | - | |
| k | 0.02 | 0.64 | 1.53 | 0.027 | 0.009 | 25.25 | 24.75 | 2.65 | - | Nb+Ta 0.43 |

EP 0 461 843 A2

| | | | | | | | | | | |
|---|---|---|---|---|---|---|---|---|---|---|
| l | 0.019 | 0.65 | 1.54 | 0.034 | 0.007 | 11.49 | 20.79 | 2.43 | 0.206 | |
| m | 0.055 | 3.31 | 0.56 | 0.023 | 0.003 | 13.03 | 18.85 | 0.09 | - | |
| n | 0.07 | 0.54 | 1.45 | 0.019 | 0.013 | 21.33 | 24.41 | 2.21 | - | |
| o | 0.017 | 0.66 | 1.28 | 0.031 | 0.003 | 12.10 | 17.50 | 2.06 | - | |
| p | 0.010 | 0.46 | 0.35 | 0.017 | 0.001 | 24.94 | 22.98 | 5.74 | 0.183 | |
| q | 0.059 | 0.66 | 0.50 | 0.030 | 0.001 | 8.35 | 19.09 | 0.51 | 0.128 | |
| r | 0.064 | 0.75 | 1.51 | 0.033 | 0.009 | 13.74 | 18.29 | 3.34 | - | |
| s | 0.060 | 0.65 | 1.64 | 0.032 | 0.002 | 13.90 | 22.41 | 0.04 | - | |
| t | 0.05 | 3.50 | 0.54 | 0.031 | 0.003 | 12.42 | 18.43 | - | - | Cu 1.51 |
| u | 0.045 | 0.66 | 1.45 | 0.028 | 0.008 | 10.36 | 17.48 | - | - | Nb+Ta 0.65 |

EP 0 461 843 A2

At the outset, two sheets of each of individual aluminum alloys respectively having compositions 1 to 7 and individual stainless steels respectively having compositions a to u were prepared. In the present example, these sheets were cleaned or wiped with a gauze immersed in first grade ethyl alcohol (hereinafter referred simply as "ethyl alcohol") and then allowed to stand until the ethyl alcohol was evaporated. A spray type acrylic lacquer manufactured by Asahipen Corp. (trade name: Ultramarine) was spray-coated on the surface cleaned with a gauze immersed in ethyl alcohol with respect to one of two sheets of each of the aluminum alloys and stainless steels.

With respect to the remaining one sheet of each of the aluminum alloys and the stainless steels, the surface wiped with a gauze immersed in ethyl alcohol was irradiated in the air with an ultraviolet light emitted from a tow-pressure mercury lamp (output: 200 W, Model: SUV-200GS) manufactured by SEN Lights Corp.) for 60 sec from a position 65 mm distance from the wiped surface. One hr after the completion of the irradiation, "Ultramarine" manufactured by Asahipen Corp. was spray-coated on the exposed surface of each sample.

Each sample after the coating was allowed to stand in a room for 48 hr, thereby drying the coating.

The samples were subjected to a crosscut test in the same manner as that of Example 1 to determine the remaining coating percentage. The remaining coating percentage for the aluminum alloys respectively having compositions 1 to 7 is shown in Table 10 which will be given later, and the remaining coating percentage for the stainless steels respectively having compositions a to u is shown in Table 11 which will be given later. In Tables 10 and 11, the term "treated sample" is intended to mean a sample subjected to coating after irradiation with an ultraviolet light emitted from a tow-pressure mercury lamp, while the term "untreated sample" is intended to mean a sample not subjected to the ultraviolet irradiation.

## Table 10

### (Surface modification effect on various aluminum alloys)

| Composition | Remaining coating percentage (%) | |
|:---:|:---:|:---:|
| | Untreated sample | Treated Sample |
| 1 | 0 | 100 |
| 2 | 55 | 100 |
| 3 | 0 | 100 |
| 4 | 0 | 100 |
| 5 | 25 | 100 |
| 6 | 60 | 100 |
| 7 | 60 | 100 |

## Table 11

### (Surface modification effect on various stainless steels)

| Composition | Remaining coating percentage (%) | |
|---|---|---|
| | Untreated sample | Treated Sample |
| a | 25.0 | 100 |
| b | 1.2 | 100 |
| c | 24.0 | 100 |
| d | 1.2 | 100 |
| e | 15.0 | 100 |
| f | 3.2 | 100 |
| g | 0.0 | 100 |
| h | 0.0 | 100 |
| i | 0.0 | 99.8 |
| j | 4.0 | 100 |
| k | 4.0 | 99.9 |
| l | 0.0 | 100 |
| m | 0.0 | 100 |
| n | 40.0 | 100 |
| o | 0.0 | 100 |
| p | 0.0 | 100 |
| q | 0.4 | 100 |
| r | 0.8 | 100 |
| s | 33.0 | 100 |
| t | 16.0 | 100 |
| u | 47.2 | 100 |

As is apparent from Tables 10 and 11, the method of modifying a metallic surface according to the present invention enables the surface of aluminum-based alloys and the surface of stainless steels having various compositions to be modified to a state suitable for adhesion of a material to be provided thereon.

As is apparent from the composition, the aluminum alloy having composition 1 used in the experiment falls within the scope of aluminum alloy of 1000 series specified in Japanese Industrial Standards, white the aluminum alloys having compositions 2 to 7 respectively fall within the scope of aluminum alloy of 2000 to 7000 series specified in Japanese Industrial Standards. This renders the method of modifying a metallic surface according to the present invention suitable for the surface modification of not only pure aluminum but also various aluminum alloys. In the present specification, detailed description on compositions and applications of aluminum alloys specified in Japanese Industrial Standards will be omitted because they are given in, for example, "Aluminium Handobukku (Aluminum Handbook) published on May 1, 1987 by Japan Light Metal Association.

In the case of the stainless steels as well, a surface modification effect could be confirmed on currently used stainless steels having various compositions, which renders the present invention widely applicable to the surface modification of various metals.

EXAMPLE 3: Dependence of the degree of surface modification of pure aluminum on the kind of irradiation lamp

The present example demonstrates the surface modification of pure aluminum with variation in the kind of the ultraviolet irradiation lamp for the surface modification and ultraviolet irradiation conditions as given in Table 13 which will be described later. Model: HL-2000DS manufactured by SEN Lights Corp., Model: HL-2000DL manufactured by the same company, Model: SUV-110WL (two-lamp type) and Model: SUV-200GS manufactured by the same company were used as a high-pressure (or medium-pressure) mercury lamp made of fused quartz, a high-pressure (or medium-pressure) mercury lamp made of synthetic quartz, a low-pressure mercury lamp made of fused quartz and a low-pressure mercury lamp made of synthetic quartz, respectively.

Table 13

Dependence of degree of surface modification of pure aluminum on type (wavelength) of lamp

| Type of lamp | Distance between lamp and treated material | Irradiation time (sec) | Intensity of light at 365 nm $(mW/cm^2)$ | Intensity of light at 254 nm $(mW/cm^2)$ | Integrating luminous energy of 254-nm light $(mJ/cm^2)$ | Remaining Coating Percentage % |
|---|---|---|---|---|---|---|
| High-pressure mercury lamp made of fused quartz | 50 cm<br>25 cm<br>6.5 cm | 60<br>60<br>60 | 34.6<br>143<br>686 | 2.75<br>7.56<br>43.56 | 165<br>453.6<br>2613.6 | 0<br>46<br>100 |
| High-pressure mercury lamp made of Synthetic quartz | 50 cm<br>25 cm<br>6.5 cm | 60<br>60<br>60 | 36.4<br>148<br>537.6 | 8.14<br>24.27<br>137.4 | 488<br>1456.2<br>8244 | 100<br>100<br>100 |
| Low-pressure mercury lamp made of fused quartz | position where 254 nm-light is obtained at 7 mW/cm² | 60<br>90<br>120 | —<br>—<br>— | 7<br>7<br>7 | 420<br>630<br>1260 | 0<br>96<br>100 |
| Low-pressure mercury lamp made of Synthetic quartz | position where 254 nm-light is obtained at 10.5 mW/cm² | 40<br>60<br>120 | —<br>—<br>— | 10.5<br>10.5<br>10.5 | 420<br>630<br>1260 | 100<br>100<br>100 |
| Low-pressure mercury lamp made of Synthetic quartz ($N_2$ flow) | position where 254 nm-light is obtained at 10.5 mW/cm² | 40<br>60<br>120 | —<br>—<br>— | 10.5<br>10.5<br>10.5 | 420<br>630<br>1260 | 100<br>100<br>100 |

EP 0 461 843 A2

In Table 13, the intensity of light at 365 nm and the intensity of light at 253.7 nm (in Table 13, referred to as "254 nm") were measured by Model 306 UV illumination meter (or illuminometer or radiometer) (for use in 254 nm as well as in 365 nm) manufactured by OAI Company in U.S.A. (Model 306; brand of SEN Lights Corp.). The pure aluminum used was the same commercially available one as that used in EXAMPLE 1. Since the surface of the pure aluminum has been recognized as being clean when observed with the naked eye, the aluminum was irradiated as such (without any washing) with an ultraviolet light under conditions given in Table 13. Thereafter, the irradiated aluminum was spray-coated with a spray type acrylic lacquer (black color) manufactured by Asahipen Corp. Each sample after the completion of the coating was left to stand in a room for 4 hr, thereby drying the coating. Thereafter, each sample was subjected to a crosscut test in the same manner as that of EXAMPLE 1, and the modification effect was evaluated based on the percentage remaining coating. The percentage remaining coating on each sample is given in the above-described Table 13.

As is apparent from Table 13 on columns for the high-pressure mercury lamp made of fused quartz, the high-pressure mercury lamp made of synthetic quartz and the low-pressure mercury lamp made of fused quartz, the remaining coating percentage in the case of the pure aluminum is not influenced by an intensity difference in the 365 nm-light and increases with increasing the intensity of the 253.7 nm-light. Further, it is understood that the irradiation of the pure aluminum with the 253.7 nm-light at an exposure of at least 480 mJ/cm$^2$ suffices for obtaining in the pure aluminium a percentage remaining coating sufficient for practical use.

Further, as is apparent from Table 13 on columns for the low-pressure mercury lamp made of synthetic quartz, the percentage remaining coating becomes 100 % even at an exposure of the 235.7 nm-light of 420 mJ/cm$^2$ when use is made of a low-pressure mercury lamp made of synthetic quartz. In this case, an irradiation timeof 40 sec is sufficient. This is because the low-pressure mercury lamp made of synthetic quartz emits a 184.9 nm-light in addition to the 253.7 nm-light. These fact show that when use is made of an ultraviolet light having a 253.7 nm-light and a 184.9 nm-light, surface modification effect can be attained in a shorter time than the case where use is made of an ultraviolet light having a 253.7 nm-light but not having a 184.9 nm-light.

Further, in Table 13, as with the ultraviolet irradiation in the air, the percentage reamining coating in the case where use was made of low-pressure mercury lamp made of synthetic quartz and the ultraviolet irradiation was conducted in a nitrogen atmosphere became 100%. Therefore, it is possible to conduct a surface modification capable of impriving the coating adhesion also in the case of an ultraviolet irradiation in nitrogen atmosphere. The above-described experiment is a sole experiment on the use of nitrogen as the ultraviolet irradiation atmosphere, and no more detailed experiment was conducted. However, the above results apparently suggest the possibility of formation of a nitride film suitable for adhesion of a material to be provided thereon to be formed on the surface of aluminum. As to oxide films, a similar effect to that previously described may be applicable.

Separately, an experiment was conducted in the same manner as that described above, except that the surface of the pure aluminum was wiped with a gauze immersed in ethyl alcohol. As a result, no special effect derived from the wiping with ethyl alcohol was attained. This shows that, according to a surface modification method embodying the present invention, the metallic surface can be modified without conducting any special washing before the ultraviolet irradiation.

EXAMPLE 4: Dependence of the degree of surface modification of SUS-304 on the kind of irradiation lamp

A surface modification effect was examined in the same manner as that of EXAMPLE 3 (conditions given in Table 13), except that SUS-304 was used instead of the pure aluminum as the material to be treated.

As a result, a remaining coating percentage of 44 % was obtained in a sample irradiated with an ultraviolet light emitted from a high-pressure (or medium-pressure) mercury lamp made of fused quartz located at a position 50 cm distance from the sample for 1 min. In all the other samples, the remaining coating percentage was 100 %. The experimental results show that in the case of SUS-304 the surface modification effect can be attained in a weaker ultraviolet irradiation condition than that used in aluminum.

COMPARATIVE EXAMPLE 4: Treatment with ozone atone

The following treatment was conducted in the present COMPARATIVE EXAMPLE 4.

Pure aluminum was cleaned or wiped with a gauze immersed in ethyl alcohol and then rinsed with ethyl alcohol. Thereafter, the pure aluminum was allowed to stand until ethyl alcohol was removed through evaporation. Then, the aluminum was exposed to ozone. An ozone generator (Model LP-150) manufactured by Ozone Corp. (Japanese Corp.) was used for the generation of ozone. The aluminum was provided at a position 1 cm distant from the ozone generator and exposed to ozone for 1 min in one sample and 5 min in another sample. The sample were then spray-coated with a spray type acrylic lacquer (trade name: Ultramarine) without irradiation with an ultraviolet light. After the completion of the coating, each sample was then allowed to stand as such for 48 hr, thereby drying the resulting coating. Thereafter, the samples were subjected to a crosscut test in the same manner as that of Example 1, and the modification effect was evaluated based on the percentage remaining coating.

The sample exposed to ozone for 1 min exhibited a percentage remaining coating of 0 (zero) %. On the other hand, the sample exposed to ozone for 5 min exhibited a percentage remaining coating of 0. 4 %.

From the above results, it is apparent that the exposure of aluminum to only ozone provides no satisfactory results.

In the above-described examples, the method of modifying a metallic surface according to the present invention was specifically described. In this connection, however, it should be noted that the metals usable in the present invention are not limited to the above-described metals only. Further, the metals are not limited to crystalline metals and may be amorphous.

Further, it should be noted that treatment conditions, such as exposure and atmosphere in the irradiation of the metallic surface with the ultraviolet light are not limited to those used in the above-described examples and may be property altered depending upon the material and shape of the metallic surface to be treated. For example, it is a matter of course that an oxygen gas may be flowed during the irradiation.

Furthermore, the treatment conditions may be changed depending on a kind of a material to be treated and/or its composition. As a material to be provided on a metallic surface may be used, for example, paints, adhesive, inks, plating and coating resins.

Further, in the above-described examples, various tamps were used alone. Alternatively, the ultraviolet irradiation may be conducted through the use of a combination of a plurality of lamps, for example, a combination of a high-pressure (or medium-pressure) mercury lamp made of synthetic quartz with a low-pressure mercury lamp made of synthetic quartz.

## Claims

1. A method of modifying a metallic surface, which method comprises modifying a metallic surface having a poor adhesion to a material to be provided thereon before the material is provided on the surface of said metal,

   wherein the surface of said metal is irradiated with ultraviolet light having a 253.7 nm-wavelength.

2. A method of modifying a metallic surface, which method comprises modifying a metallic surface having a poor adhesion to a material to be provided thereon before the material is provided on the surface of said metal,

   wherein the surface of said metal is irradiated with ultraviolet light having a 184.9 nm-wavelength and a 253.7 nm-wavelength.

3. A method of modifying a metallic surface according to claim 1 or claim 2, wherein said metal is aluminum, an aluminum-based alloy, a stainless steel, galvanized steel sheet or tin coated steel sheet.

4. A method of modifying a metallic surface according to claim 1, wherein said metal is aluminum or an aluminum-based alloy and is irradiated with the ultraviolet light at an exposure of 500 mJ/cm$^2$ in terms of the light having the 253.7 nm-wavelength.

5. A method of modifying a metallic surface according to claim 2, wherein said metal is aluminum or an aluminum-based alloy and is irradiated with the ultraviolet light at an exposure of 400 mJ/cm$^2$ in terms of the light having the 253.7 nm-wavelength.

6. A method of modifying a metallic surface according to claim 2 or claim 5, wherein the ratio ($P_{254}/P_{185}$) of the light intensity at 253.7 nm ($P_{254}$) to the light intensity at 184.9 nm ($P_{185}$) is less than 60.

FIG. 1

FIG.2

RATIO OF LIGHT INTENSITY AT EACH
WAVELENGTH TO LIGHT INTENSITY AT
253.7 nm (%)

WAVELENGTH (nm)

FIG_3

DISTANCE BETWEEN LAMP AND
UV RADIOMETER (cm)

# *FIG. 4*

NUMBER OF STANDING DAYS FROM COMPLETION OF
MODIFICATION TREATMENT TO COATING OF PAINT

# FIG_5

EX. 1 (DISTANCE: 35 mm)

COMP. EX. 1 (DISTANCE: 35 mm)

COMP. EX. 3

COMP. EX. 2

IMMEDIATELY AFTER TREATMENT

REMAINING COATING PERCENTAGE AFTER CROSSCUT TEST (%)

NUMBER OF STANDING DAYS FROM COMPLETION OF MODIFICATION TREATMENT TO COATING OF PAINT

# *FIG. 6*

EX. 1 (DISTANCE: 35 mm)

COMP. EX. 1 (DISTANCE: 35 mm)

COMP. EX. 2

COMP. EX. 3

REMAINING COATING PERCENTAGE AFTER CROSSCUT TEST (%)

IMMEDIATELY AFTER TREATMENT

NUMBER OF STANDING DAYS FROM COMPLETION OF MODIFICATION TREATMENT TO COATING OF PAINT